# EUROPEAN PATENT SPECIFICATION

(11) **EP 3 224 536 B1**
(45) Date of publication and mention of the grant of the patent: **26.01.2022**
(21) Application number: 14907073.2
(22) Date of filing: 24.11.2014
(51) Int. Cl.: F21V 8/00

(54) **LIGHT EMISSION STRUCTURE AND DEVICE WITH LIGHT EMISSION STRUCTURE**
LICHTEMITTIERENDE STRUKTUR UND VORRICHTUNG MIT LICHTEMITTIERENDER STRUKTUR
STRUCTURE ÉLECTROLUMINESCENTE ET DISPOSITIF À STRUCTURE ÉLECTROLUMINESCENTE

(43) Date of publication of application: 04.10.2017
(73) Proprietor: InterDigital Madison Patent Holdings, SAS, 75017 Paris (FR)
(72) Inventor: HUANG, Wenxin, Beijing 100192 (CN); ZHOU, Zuke, Beijing 100192 (CN); QIN, George, Beijing 100192 (CN)
(74) Representative: AWA Sweden AB
(86) International application number: PCT/CN2014/092012
(87) International publication number: WO 2016/082068

(56) References cited:
- CN-A- 102 905 489
- CN-A- 103 037 649
- CN-U- 201 836 817
- CN-U- 202 443 144
- CN-U- 202 795 150
- CN-Y- 2 837 866
- US-A- 5 760 754
- US-A1- 2007 153 529
- US-A1- 2010 238 667
- None

## Description

### FIELD

The present disclosure generally relates to a light emission structure, in particular a light emission structure to guide light from a light source.

### BACKGROUND

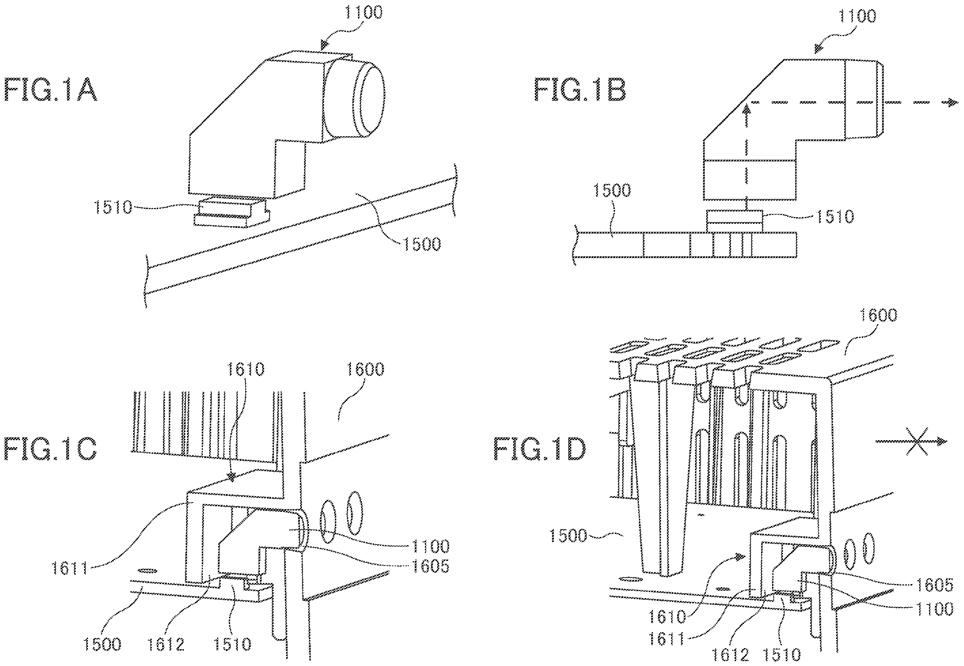

FIGs. 1A-1D illustrates one example of a light emission structure in the related art.

As shown in FIGs. 1A and 1B, a light guide 1100, as one example of a light emission structure in the related art, is mounted on a Printed Circuit Board (PCB) 1500 in a state where the light guide 1100 is positioned above a light source (i.e., a Light-Emitting Diode (LED) or so) 1510 provided on the PCB 1500. As a result, light emitted by the light source 1510 is incident on the light guide 1100. Then, as shown by arrows drawn with broken lines in FIG. 1B, the incident light is transmitted through the inside of the light guide 1100 which then emits the light.

US 2007153529, US 2010238667 and US5760754 disclose light emission structures.

### SUMMARY

According to the present invention, a light emission structure includes a light guiding space defining portion configured to define a light guiding space having a light reception opening and a light emission opening, the light guiding space being configured to receive light emitted by a light source provided on a circuit substrate through the reception opening and guide the introduced light to radiate through the emission opening; and a holding portion configured to have holding arms for holding the circuit substrate. At least a part of the light guiding space defining portion abutting the circuit substrate and a part of the holding portion abutting the circuit substrate are made of a soft material.

Other objects, features and advantages of the present disclosure will become more apparent from the following detailed description when read in conjunction with the accompanying drawings.

### BRIEF DESCRIPTION OF THE DRAWINGS

FIGs. 1A-1D illustrate one example of a light emission structure in the related art;
FIG. 2 is a perspective view of a light emission structure according to an embodiment of the present disclosure;
FIGs. 3A-3E are a plan view, a left side view, a front view, a right side view and a bottom view, respectively, of the light emission structure shown in FIG. 2;
FIG. 4 is a sectional view of the light emission structure shown in FIG. 2 taken along the 4-4 line of FIG. 3C;
FIGs. 5A-5D are a left-side top front view, a right-side bottom front view, a left-side rear bottom view and another left-side rear bottom view, respectively, of the light emission structure shown in FIG. 2;
FIGs. 6A-6D illustrate how to use the light emission structure shown in FIG. 2;
FIGs. 7A and 7B illustrate how to mount the light emission structure shown in FIG. 2;
FIGs. 8A and 8B illustrate a light guiding space of the light emission structure shown in FIG. 2;
FIGs. 9A and 9B illustrate a light guide mounting part of the light emission structure shown in FIG. 2; and
FIGs. 10A-10E illustrates molds in an example usable to mold the light emission structure shown in FIG. 2.

### DESCRIPTION OF EMBODIMENT

Concerning the related art, FIGs. 1C and 1D illustrate a state where the above-mentioned PCB 1500 on which the light guide 1100 is thus provided is installed in a housing 1600 of, for example, an electronic apparatus, more specifically, Set Top Box (STB), DVD or Blu-ray recorder, Hard-disk recorder and so on.

In the structure of the related art shown in FIG. 1C, light emitted by the light guide 1100 radiates outside the housing 1600 via an opening 1605 formed in the housing 1600. Thus, the light guide 1100 functions as an indicator that indicates a state in the electronic apparatus.

In such a configuration of the related art, in order to prevent the light emitted by the light source 1510 from uselessly leaking out, a light blocking room 1610 is provided to cover the light guide 1100 and the light source 1510 as shown in FIG. 1C. In this configuration, however, the light may somewhat leak outside through a gap, for example, between an upright wall 1611 of the light blocking room 1610 and the PCB 1500.

Also, in this configuration of the related art, as shown in FIG. 1D, when the PCB 1500 on which the light guide 1100 is mounted is assembled into the housing 1600 with which the light blocking room 1610 is integrally formed, the PCB 1500 is lifted so as to insert the light guide 1100 on the PCB 1500 into the light blocking room 1610 through the bottom opening 1612 thereof. Thus, it is not possible to assemble the PCB 1500 having the light guide 1100 mounted thereon into the housing 1600 in the direction of the arrow shown in FIG. 1D, for example. That is, when the PCB 1500 having the light guide 1100 mounted thereon is moved horizontally in the direction of the arrow, the upright wall 1611 of the light blocking room 1610 blocks the moving path and it is not possible to insert the light guide 1100 mounted on the PCB 1500 into the light blocking room 1610 without lifting the PCB 1500 as mentioned above.

An object of the embodiment of the present disclosure is to provide a light emission structure by which it is possible to effectively prevent light leakage and also it is possible to easily mount it and flexibly assemble it in an electronic apparatus.

The light emission structure according to the embodiment of the present disclosure is made of a soft material such as a silicon rubber. As a result, light leakage can be easily and positively prevented since, due to soft contact with another member such as a PCB, a small gap which may be otherwise created therebetween can be effectively avoided.

In addition to a soft characteristic, such a material as a silicon rubber mentioned above to be usable for the light emission structure has a resilient characteristic so that it is easy to mount it onto a PCB or such due to a restoration characteristic thereof.

Thus, the light emission structure according to the embodiment is made of, for example, a soft rubber or ThermoPlastic Elastomer (TPE) having a soft characteristic and a resilient characteristic. More preferably, the light emission structure according to the embodiment is made of, for example, a silicon rubber colored black and having hardness of shore A 60. By using a material having a color of solid black, it is possible to block light emitted by the power source to avoid light leakage effectively.

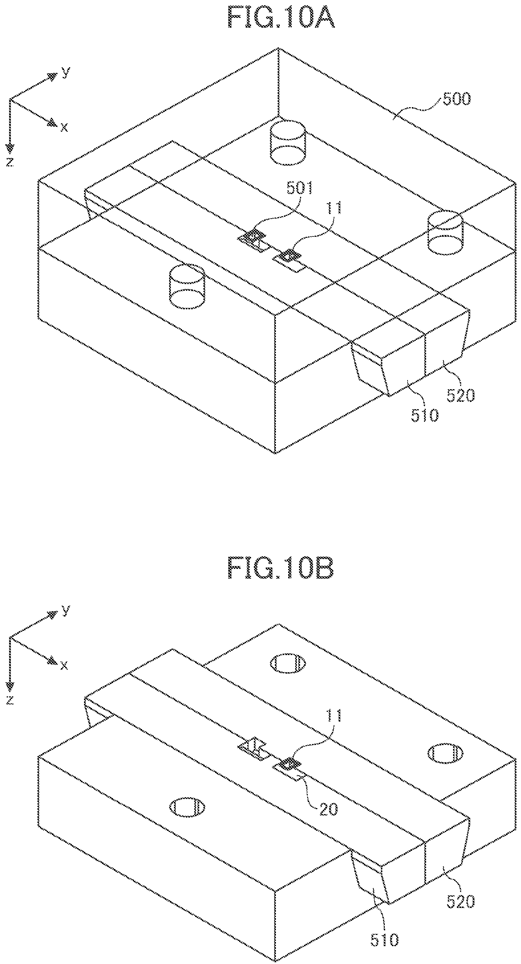

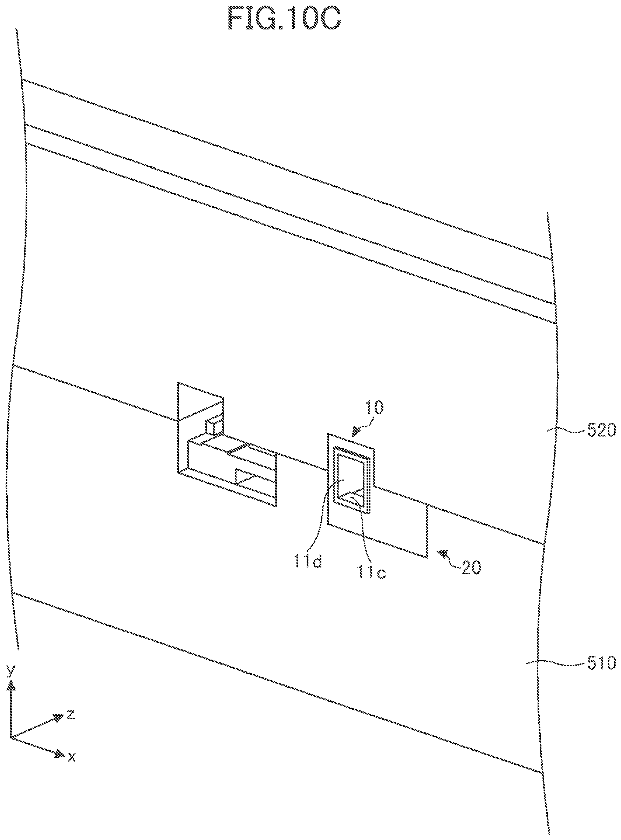

Also, the light emission structure according to the embodiment can be produced by an integral molding process. That is, the entire light emission structure according to the embodiment can be made of the same material and the light emission structure can be formed by pouring the material into molds (such as those 500, 510 and 520 shown in FIGs. 10A-10E described later).

After the molding process, a polishing process is carried out to provide mirror-like surfaces in a light guiding space 11 as will be described later.

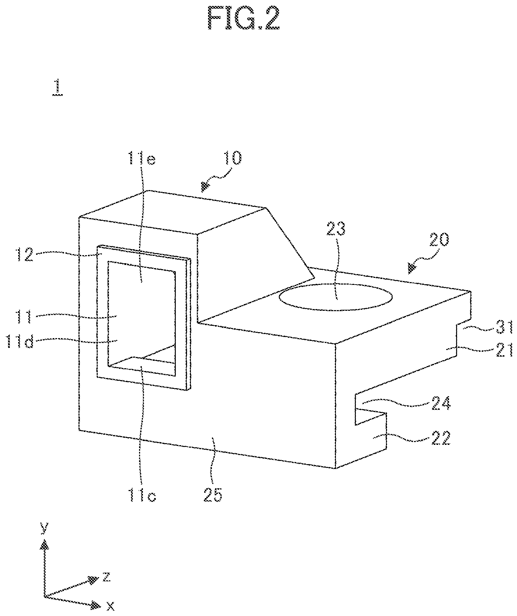

Using FIGs. 2-5D, the light emission structure 1 according to the embodiment will be described in detail. In this regard, for the sake of convenience, the threedimension x, y and z axes are shown in figures. Also, expressions such as "top", "bottom", "upper", "lower", "left", "right", and so forth, are used to explain the configuration of the light emission structure 1 and the special relationship between the light emission structure 1 and a circuit component or such or the PCB or such, and so forth. However, actual embodiments of the present disclosure are not limited in connection with such specific directions, and can be installed in any direction such as upside down, left and light sides reversed, and so forth.

As shown in the figures, the light emission structure 1 has a light guiding space defining portion 10 and a holding portion 20.

In the state shown in FIG. 2, the light guiding space defining portion 10 is an approximately left half of the light emission structure 1 and the holding portion 20 is an approximately right half of the light emission structure 1.

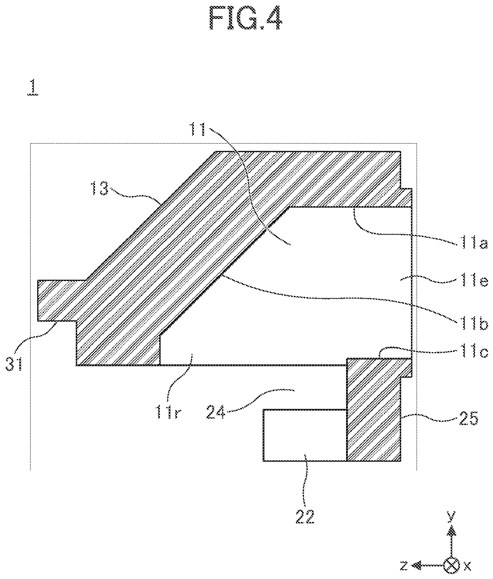

The light guiding space defining portion 10 defines the light guiding space 11 therein and has an outline like a rectangular parallelepiped whereas a rear side of a top part being cut off obliquely to have an outside sloped surface 13. As can be seen from FIG. 4, the slope of the outside sloped surface 13 is approximately the same as the slope of an inside sloped surface 11b of the light guiding space 11. As a result, it is possible to effectively reduce the size of the light emission structure 1 to make it possible to install the light emission structure in a narrow space. Also, it is possible to effectively reduce the quantity of the material needed to produce the light emission structure 1.

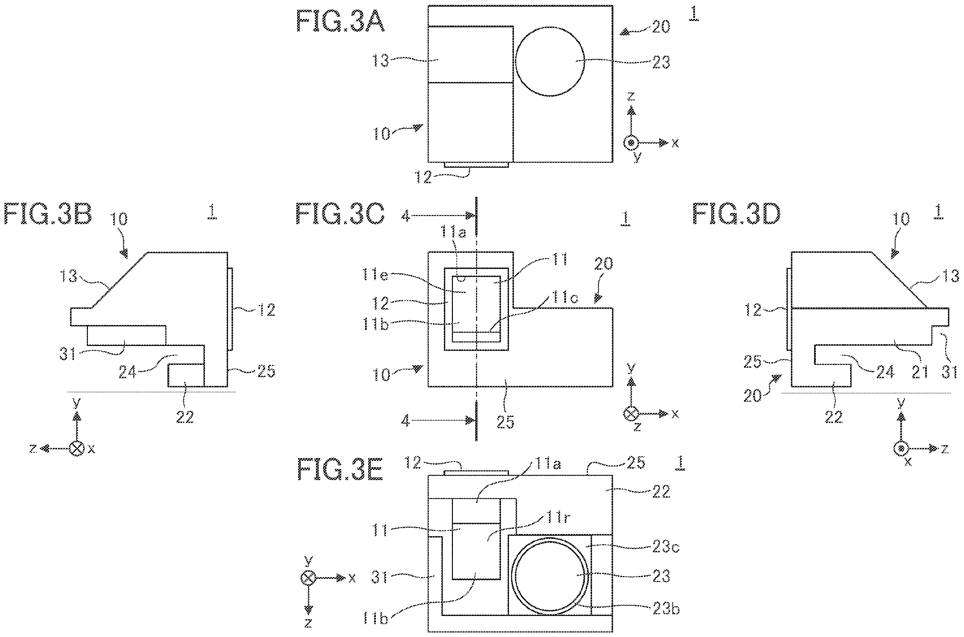

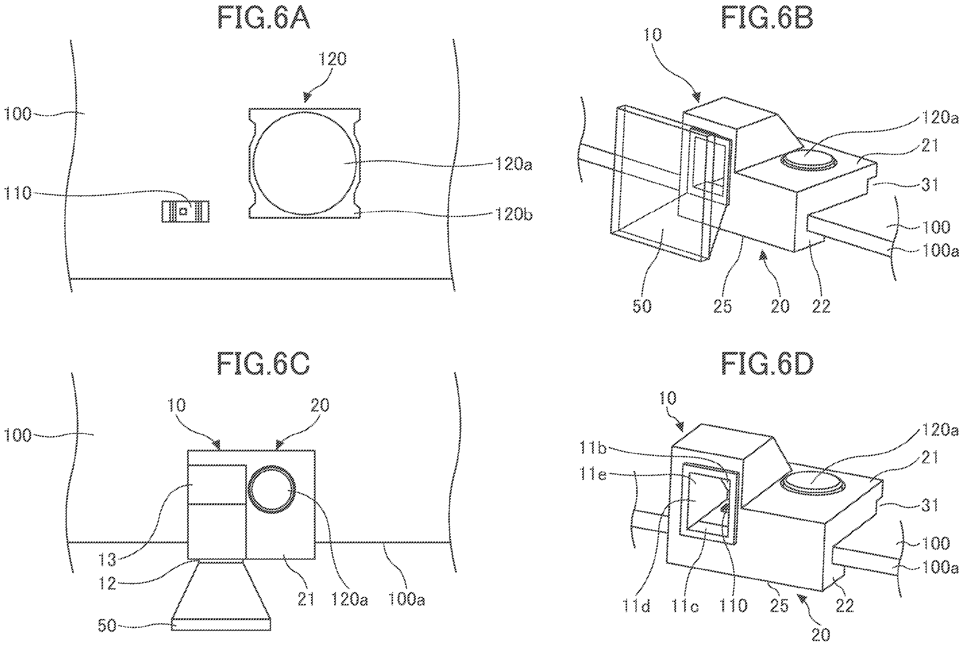

The holding portion 20 has an approximately "J" shape when viewed laterally as shown in FIGs. 3B, 3D and 4, for example. Also, the holding portion 20 has upper and lower holding arms 21 and 22 to fit an edge part of the PCB or such in a fitting space 24 therebetween, as shown in FIGs. 6B and 6D, described later.

The upper arm 21 has a clearance space 23 to allow a circuit component (such as a capacitor) or such to pass therethrough so that even if such a circuit component is provided on the PCB or such, it is possible to mount the light emission structure 1 approximately at the same position. Therefore, it is possible to install the light emission structure 1 in a narrow space.

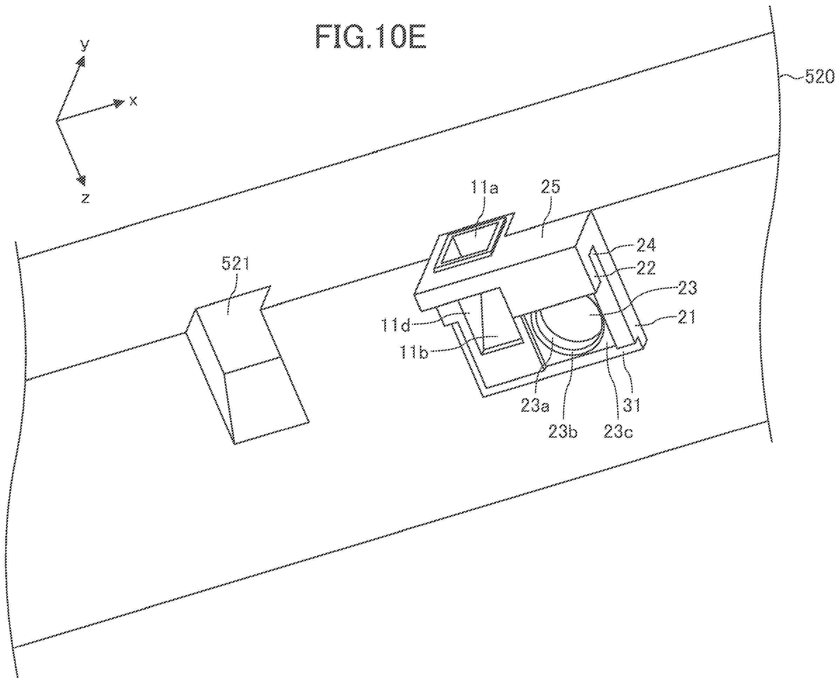

As shown in FIG. 10E, the clearance space 23 has a cylindrical part 23a, and the clearance spate 23 also can have a circular truncated cone part 23b and a rectangular parallelepiped part 23c continuously arranged downward (i.e., the -y direction) in the stated order.

The cylindrical part 23a has a cylindrical shape with a fixed inner diameter. The circular truncated cone part 23b has a circular truncated cone shape with its inner diameter continuously increasing from the cylindrical part 23a. The rectangular parallelepiped part 23c has a rectangular parallelepiped shape (without the rear wall).

As shown in FIGs. 3E, 5C, 5D and 10E, the rectangular parallelepiped part 23c has three side walls, i.e., the front, left and right walls. These three walls are outside the circular bottom edge of the circular truncated cone part 23b in plan view. Due to such a configuration of the clearance space 23 having the rectangular parallelepiped part 23c with the three walls outside the circular bottom edge of the circular truncated cone part 23b without the rear wall and the circular truncated cone part 23b with the inner diameter continuously increasing from the cylindrical part 23a, it is possible to more easily insert and fit the circuit component or such in the clearance space 23 when mounting the light emission structure 1 onto the PCB or such.

In this regard, the specific size, shape and position of the clearance space 23 are not limited to those shown in the figures and can be flexibly determined depending on an actual shape of the circuit component or such.

For example, the size of the clearance space 23 can be any size corresponding to the size of the circuit component or such. For example, if the circuit component or such has a smaller size, it is possible to reduce the size of the clearance space 23 accordingly and reduce the size of the upper holding arm 21 having the clearance space 23 correspondingly. As a result, it is possible to reduce the size of the light emission structure 1. However, in this regard, since the upper holding arm 21 is used to hold on the PCB or such in cooperation with the lower holding arm 22, the upper holding arm 21 has a sufficient size to hold on the PCB or such in cooperation with the lower holding arm 22.

Although the clearance space 23 in the present embodiment has the partially circular and rectangular cross-sectional shape as mentioned above, the cross-sectional shape of the clearance space 23 can be any other shape such as a square shape, a rectangular shape, an ellipse/oval shape or so or any combination thereof to correspond to the actual shape of the circuit component or such.

In addition, although the clearance space 23 has a shape of a through-hole, the shape of the clearance space 23 can be any other one depending on the actual shape and size of the circuit component or such. For example, the clearance space 23 can have a hole shape, a cut-out/cut-off shape or so.

The clearance space 23 can also be used as a positioning space for positioning the light emission structure 1 with respect to the PCB or such.

Although the holding portion 20 is connected with the light guiding space defining portion 10 to the right, the actual relative positional relationship between the light guiding space defining portion 10 and the holding portion 20 is not limited to that shown in the figures and can be determined in any way depending on the actual spatial relationship between the light emission structure 1 and the circuit component or such. For example, the holding portion 20 can be connected with the light guiding space defining portion 10 to the left or the light guiding space defining portion 10 can have the holding portion 20 on each side.

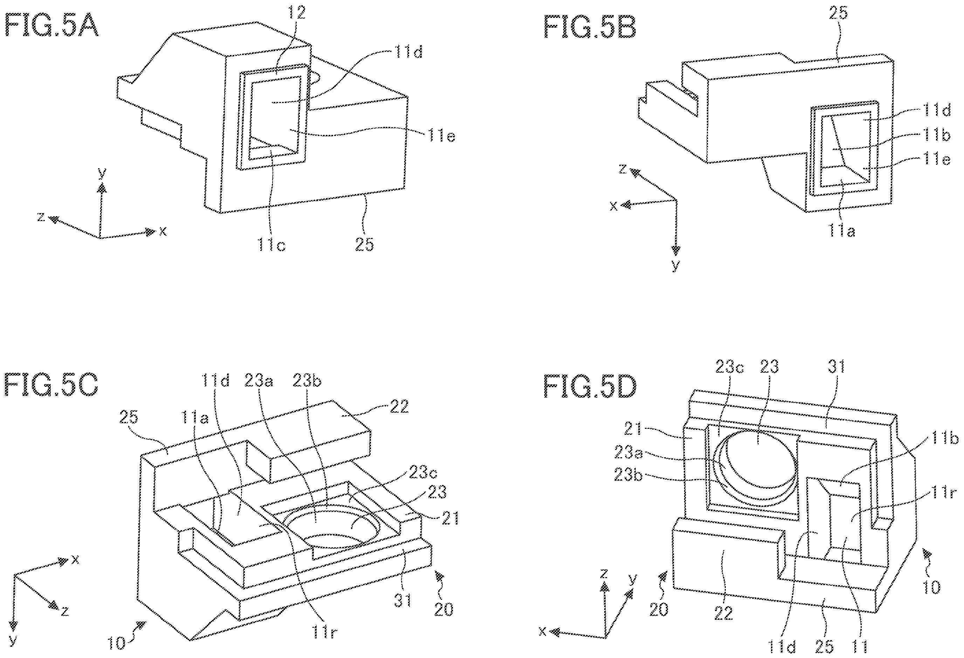

Although the lower holding arm 22 has the width approximately half the entire width of the light emission structure 1 including the light guiding space defining portion 10, it is also possible that the lower holding arm 22 has a longer width, for example, the same as the entire width of the light emission structure 1. Thereby, it is possible to more firmly hold the edge part of the PCB or such with the lower holding arm 22, the upper holding arm 21 and a bottom part of the light guiding space defining portion 10. As can be seen from FIGs. 5C, 5D and 10E, the bottom surface of the light guiding space defining portion 10 and the bottom surface of the upper holding arm 21 form a continuous flat surface like an "S" shape. The continuous flat surface is used to hold the edge part of the PCB in cooperation with the lower holding arm 22 by sandwiching it in the fitting space 24. Therefore, if the lower holding arm 22 is thus elongated leftward (in the -x direction) to have the same width as the entire light emission structure 1, the light emission structure 1 can more firmly hold the edge part of the PCB or such.

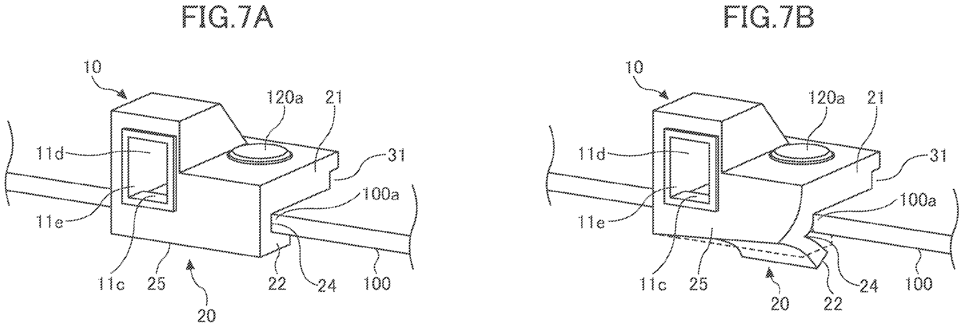

In this regard, as will be described later using FIGs. 7A and 7B, when the light emission structure 1 is mounted onto the edge part of the PCB 100, the lower holding arm 22 is bent and opens downward as shown in FIG. 7B so as to make it possible to bring the upper holding arm 21 above the component 120 to fit the component 120 in the clearance space 23. Therefore, when performing the above-mentioned operation of bending and opening the lower holding arm 22 downward by a finger of a worker, the lower holding arm 22 is preferably not too hard to be sufficiently bent so as to open the lower holding arm 22 to make it possible to bring the upper holding arm 21 above the component 120 to fit the component 120 in the clearance space 23. From this viewpoint, the above-mentioned modification of the lower holding arm 22 to elongate it to have the entire width of the light emission structure 1 may be preferably avoided.

As shown in FIGs. 5C and 5D, for example, the lower holding arm 22 is connected with the upper holding arm 21 via a connection plate 25 which extends downward and laterally throughout the entire width of the light emission structure 1 and thus is also connected with the light guiding space defining portion 10. As a result, when the light emission structure 1 is mounted onto the edge part of the PCB 100, the light emission structure 1 fits with the laterally extending edge part of the PCB 100 as the rear surface of the connection plate 25 abut an edge face 100a of the edge part of the PCB 100 throughout the entire width of the light emission structure 1, as shown in FIGs. 6B and 6D. However, the connection plate 25 may be reduced in its width to only the same as the lower holding arm 22. Thereby, it is possible to reduce the quantity of the material needed for this purpose.

As shown in FIGs. 5C and 5D, for example, a peripheral cut-out 31 is provided having a shape like "L" in plan view. The peripheral cut-out 31 extends continuously along left and rear edges of the bottom face of the light guiding space defining portion 10 and a rear edge of the bottom face of the upper holding arm 21. As a result of the rear bottom edge of the upper holding arm 21 being thus cut out, the above-mentioned rear wall of the rectangular parallelepiped part 23c in the clearance space 23 is removed. Also, as can be seen from FIGs. 6A-7B, a worker can easily handle the light emission structure 1 by inserting his or her finger between the top side of the PCB or such and the peripheral cut-out 31.

Using FIG. 6A-6D, how to use the light emission structure 1 will now be described in more detail.

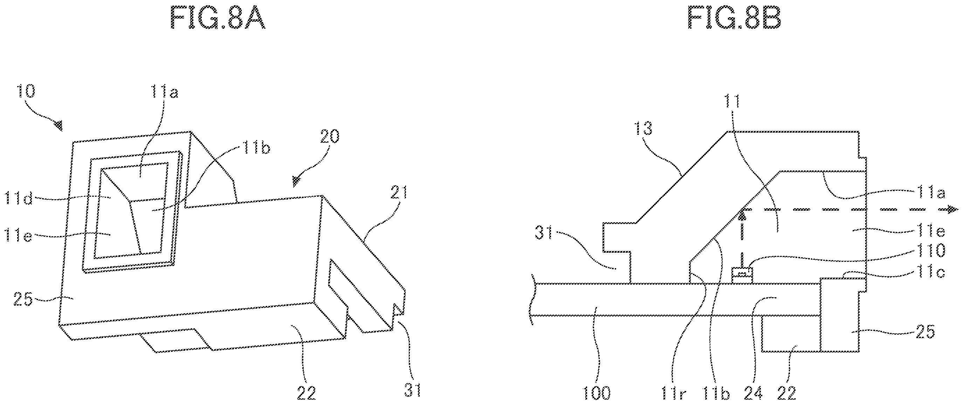

For example, the light emission structure 1 in FIG. 2 can be used in a set-top box (STB) and others as a pilot lamp to indicate whether the power is turned on in the set-top box. When the power is turned on in the set-top box, a light source 110 (for example, an LED) mounted on the PCB 100 (see FIG. 6A) assembled in the set-top box is turned on. The light is then emitted by the light source 110 and is reflected in the light guiding space 11 after passing through a light reception opening 11r and is emitted from a light emission opening 11e of the light guiding space 11 as shown in FIG. 8B. Actually, a light guide member 50 is mounted onto the light emission opening 11e which transmits the light emitted from the light emission opening 11e. For this purpose, the light guide member 50 is made of, for example, a clear PolyCarbonate (PC). A user/operator sees the light thus emitted through the light guide member 50 and understands that the set-top box is turned on or in standby mode and so on. An adhesive or such can be used to fasten the light guide member 50 to the light emission opening 11e.

As mentioned above, in the example of FIGs. 6A-6D, the circuit component (capacitor or so) 120 is mounted on the PCB 100 near the light source 110. This component 120 has a base part 120b having four corners and a main part 120a having a circular shape in plan view, as shown in FIG. 6A. When the main part 120a is fitted into the clearance space 23, it is fitted into the above-mentioned cylindrical part 23a and the circular truncated cone part 23b, and the base part 120b is fitted into the rectangular parallelepiped part 23c as shown in FIGs. 5C and 5D .

Using FIGs. 7A and 7B, how to mount the light emission structure 1 to the PCB 100 will now be described in detail.

The vertical distance of the fitting space 24 between the upper and lower holding arms 21 and 22 can be determined to be approximately the same as the thickness of the PCB. The light emission structure 1 is fitted to the edge part of the PCB 100 using the soft and resilient characteristics of the material of the light emission structure 1, for example, a silicon rubber colored black and having hardness of shore A 60, mentioned above.

FIG. 7A illustrates a state where the light emission structure 1 is fitted to the edge part of the PCB 100. FIG. 7B illustrates a state where the light emission structure 1 is being fitted to the edge part of the PCB 100.

As shown in FIG. 7B, by opening downward the lower holding arm 22 using the soft and resilient characteristics with a finger of a worker to widen the fitting space 24, it is possible to bring the upper holding arm 21 to such a position that the clearance space 23 is just above the component 120 while the thus opened lower holding arm 22 is at the edge face 100a of the edge part of the PCB 100. Then, the worker lowers the upper holding arm 21 to allow the component 120 to fit into the clearance space 23. After that, the worker removes his or her finger from the lower holding arm 22 whereby the lower holding arm 22 moves upward by itself due to the resilient characteristic to return to the original position and abuts the bottom side of the edge part of the PCB 100, as shown in FIG. 7A. Thus, the light emission structure 1 is properly mounted onto the PCB 100.

After thus fitting the light emission structure 1 to the edge part of the PCB 100 as shown in FIG. 7A, the above-mentioned "S" shaped continuous flat surface of the bottoms of the upper holding arm 21 and the light guiding space defining portion 10 and the inner faces of the lower holding arm 22 and the connection plate 25 abut or are in contact with the top and bottom sides and the edge face 100a of the edge part of the PCB 100 due to the soft and resilient characteristics of the material of the light emission structure 1. As a result, light leakage between the light emission structure 1 and the PCB 100 can be effectively avoided.

When the PCB 100 on which the light emission structure 1 is thus mounted is assembled in a housing of the set-top box, the PCB 100 can be assembled in the housing in any direction. This is because, since the light emission structure 1 has the good light leakage preventing performance by itself as mentioned above, such a member as the light blocking room 1610 mentioned above using FIGs. 1A-1D is not necessary. Therefore, the PCB 100 having the light emission structure 1 thus mounted can be assembled in the housing in any direction.

Using FIGs. 8A and 8B, the light guiding space 11 will now be described in more detail.

As mentioned above, the light guiding space 11 is acquired through a polishing process of polishing a top face 11a, an oblique face 11b, a bottom face 11c and (left and right) side faces 11d of the light guiding space 11, as shown in FIGs. 8A and 8B. By thus polishing the respective faces 11a, 11b, 11c and 11d, mirror-like surfaces can be acquired for the respective faces 11a, 11b, 11c and 11d.

As a result, as shown in FIG. 8B, light emitted by the light source 110 is reflected by the oblique face 11b after passing through the light reception opening 11r, the direction of the light is thus changed and the reflected light is emitted from the light emission opening 11e. Also, the other faces 11a, 11c and 11d of the light guiding space 11 reflect any scattering light or so to avoid degradation of the light transmission efficiency.

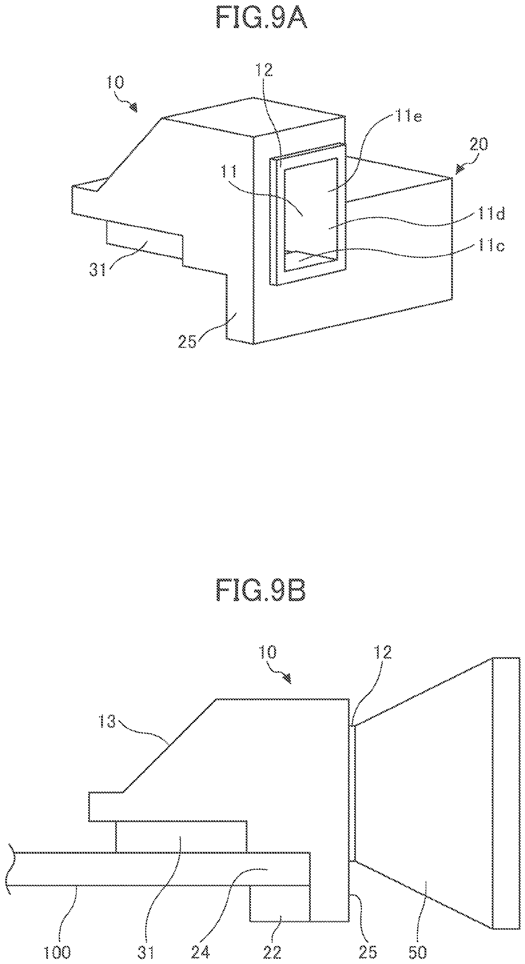

Using FIGs. 9A and 9B, a light guide mounting part 12 for mounting the light guide member 50 mentioned above will be described in more detail.

As shown in FIGs. 9A and 9B, the light guide mounting part 12 is provided at a position surrounding the light emission opening 11e to project from the front face of the light guiding space defining portion 10. When the light emission structure 1 is produced by the integral molding process, the light guide mounting part 12 can be produced together using the same material as the light emission structure 1. It is also possible to produce the light guide mounting part 12 separately from the light emission structure 1 and mount the light guide mounting part 12 onto the light emission structure 1 using an adhesive or so. By using a soft material the same as the light emission structure 1 or different from the material of the light emission structure 1, it is possible to effectively avoid light leakage which may otherwise occur between the light emission opening 11e and the light guide member 50.

Using FIGs. 10A-10E, the integral molding process will be now described in more detail.

FIGs. 10A show a front mold 500, a lower mold 510 and an upper mold 520. For the sake of convenience of explanation, in each figure of FIGs. 10A-10E, the two states are shown, side by side. The left side state is a state where no product is present in a hole (having a shape corresponding to the product to mold) while the right side state is a state where an actual product is present in the hole. Further, in FIG. 10A, the front mold 500 is shown in a see-through manner such that the shape can be easily understood.

The front mold 500, as shown in FIG. 10A, has a projection 501 (viewed from the rear side) (the left side) corresponding to the light guiding space 11 which is shown in FIG. 10A (the right side).

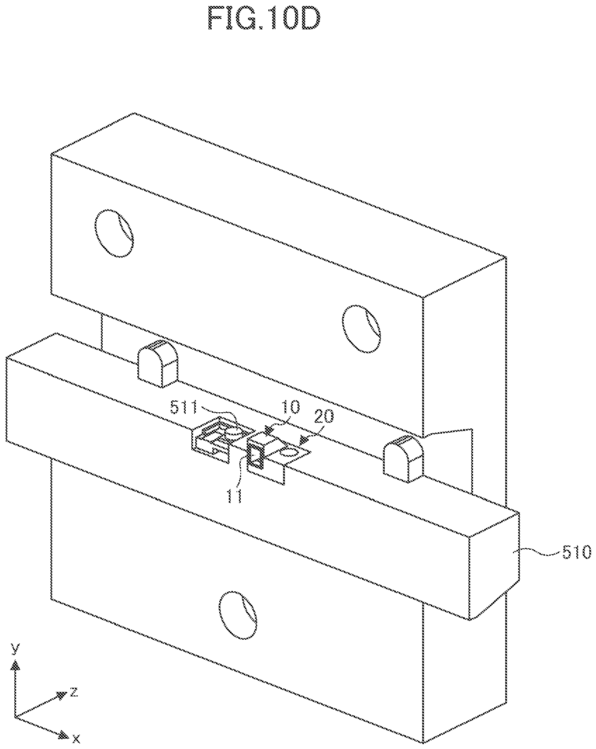

The lower mold 510, as shown in FIG. 10D, has the shape (the left side) corresponding to a lower half of the light emission structure 1 which is shown in FIG. 10E (the right side). For example, the lower mold 510 has a projection 511 corresponding to the clearance space 23 (see FIGs. 10D and 10E, for example).

The upper mold 520, as shown in FIG. 10E, has the shape (the left side) corresponding to an upper half of the light emission structure 1 which is shown in FIG. 10D (the right side). For example, the upper mold 520 has a hole 521 (see FIG. 10E) corresponding to a top part of the light guiding space defining portion 10.

Thus, the light emission structure has been described by the specific embodiment. However, the present disclosure is not limited to the present embodiment, and variations and replacements can be made within the scope of the claimed disclosure. The invention is defined in the appended claims.

## Claims

1. A light emission structure (1) comprising:
a light guiding space defining portion (10) configured to define a light guiding space (11) having a light reception opening (11r) and a light emission opening (11e), the light guiding space (11) being configured to receive light emitted by a light source provided on a circuit substrate (100) through the reception opening (11r) and reflect the introduced light to radiate through the emission opening (11e), wherein an inside wall of the light guiding space (11) has a mirror-like surface; and
a holding portion (20) provided adjacent to the light guide space defining portion along an edge part of the circuit substrate for holding the edge part of the circuit substrate (100), wherein at least a part of the light guiding space defining portion (10) abutting the edge part of the circuit substrate (100) and a part of the holding portion (20) abutting the circuit substrate (100) are made of a soft and resilient material.

2. The light emission structure (1) as claimed in claim 1, wherein the light guiding space defining portion (10) has a light guide mounting part (12) configured to project from a light emission opening surrounding part surrounding the light emission opening (11e) to have a light guide mounted thereto, wherein the light guide mounting part (12) is configured to prevent light leakage at a position where the light guide is mounted.

3. The light emission structure (1) as claimed in any one of claims 1-2, wherein the light guiding space defining portion (10) and the holding portion (20) are produced together by an integral molding process.

4. The light emission structure (1) as claimed in any one of claims 1-3, wherein the holding portion (20) is configured to have holding arms (21, 22) for holding the circuit substrate (100), and at least one of the holding arms (21, 22) is further configured to define a positioning space to have a component mounted on the circuit substrate (100) fitted therein so as to position the light emission structure (1) with respect to the circuit substrate (100).

5. The light emission structure (1) as claimed in claim 4, wherein at least one of the holding arms (21, 22) is made of an elastic material so that, when the holding arms (21, 22) start to hold the circuit substrate (100), the at least one of the holding arms (21, 22) is bent to increase a distance between respective extending ends of the holding arms (21, 22) to make it possible to insert an edge part of the circuit substrate (100) between the holding arms (21, 22) while the component mounted on the circuit substrate (100) is being fitted into the positioning space.

6. The light emission structure as claimed in one of claims 1-5, wherein the soft and resilient material is a soft rubber or thermoplastic elastomer.

7. The light emission structure as claimed in claim 5-6, wherein the soft and resilient material is a silicon rubber.

8. A device comprising a light emission structure (1) comprising:
a light guiding space defining portion (10) configured to define a light guiding space (11) having a light reception opening (11r) and a light emission opening (11e), the light guiding space (11) being configured to receive light emitted by a light source provided on a circuit substrate (100) through the reception opening (11r) and reflect the introduced light to radiate through the emission opening (11e), wherein an inside wall of the light guiding space (11) has a mirror-like surface; and
a holding portion (20) provided adjacent to the light guide space defining portion along an edge part of the circuit substrate for holding the edge part of the circuit substrate (100), wherein at least a part of the light guiding space defining portion (10) abutting the edge part of the circuit substrate (100) and a part of the holding portion (20) abutting the circuit substrate (100) are made of a soft and resilient material.

9. The device as claimed in claim 8, wherein the device is an electronic apparatus.

10. The device as claimed in claim 9, wherein the electronic apparatus is a Set-top box or a DVD, Blu-Ray or Hard-diskrecorder.

11. The device as claimed in claim 8, wherein the light guiding space defining portion (10) has a light guide mounting part (12) configured to project from a light emission opening surrounding part surrounding the light emission opening (11e) to have a light guide mounted thereto, wherein the light guide mounting part (12) is configured to prevent light leakage at a position where the light guide is mounted.

12. The device as claimed in claim 8 or11, wherein the light guiding space defining portion (10) and the holding portion (20) are produced together by an integral molding process.

13. The device as claimed in any one of claims 8, 11 and 12, wherein the holding portion (20) is configured to have holding arms (21, 22) for holding the circuit substrate (100), and at least one of the holding arms (21, 22) is further configured to define a positioning space to have a component mounted on the circuit substrate (100) fitted therein so as to position the light emission structure (1) with respect to the circuit substrate (100).

14. The device as claimed in claim 13, wherein at least one of the holding arms (21, 22) is made of an elastic material so that, when the holding arms (21, 22) start to hold the circuit substrate (100), the at least one of the holding arms (21, 22) is bent to increase a distance between respective extending ends of the holding arms (21, 22) to make it possible to insert an edge part of the circuit substrate (100) between the holding arms (21, 22) while the component mounted on the circuit substrate (100) is being fitted into the positioning space.

15. The device as claimed in any one of claims 8 and 11 to 14, wherein the soft material is a soft rubber or thermoplastic elastomer.

## Patentansprüche

1. Leuchtstruktur (1), die umfasst:
einen Lichtleitraum-definierenden Abschnitt (10), der dafür konfiguriert ist, einen Lichtleitraum (11) zu definieren, der eine Lichtempfangsöffnung (11r) und eine Lichtabstrahlungsöffnung (11e) aufweist, wobei der Lichtleitraum (11) dafür konfiguriert ist, Licht, das durch eine auf einem Schaltkreissubstrat (100) angeordnete Lichtquelle ausgesendet wird, durch die Empfangsöffnung (11r) hindurch zu empfangen und das herangeführte Licht so zu reflektieren, dass es durch die Emissionsöffnung (11e) hindurch strahlt, wobei eine Innenwand des Lichtleitraums (11) eine spiegelartige Oberfläche aufweist; und
einen Halteabschnitt (20), der neben dem Lichtleitraum-definierenden Abschnitt entlang eines Randteils des Schaltkreissubstrats zum Halten des Randteils des Schaltkreissubstrats (100) angeordnet ist, wobei mindestens ein Teil des Lichtleitraum-definierenden Abschnitts (10), der an dem Randteil des Schaltkreissubstrats (100) anliegt, und ein Teil des Halteabschnitts (20), der an dem Schaltkreissubstrat (100) anliegt, aus einem weichen und elastischen Material hergestellt sind.

2. Leuchtstruktur (1) nach Anspruch 1, wobei der Lichtleitraum-definierende Abschnitt (10) einen Lichtleitermontageteil (12) aufweist, der so konfiguriert ist, dass er von einem die Lichtabstrahlungsöffnung umgebenden Teil, der die Lichtabstrahlungsöffnung (11e) umgibt, vorsteht, um daran einen Lichtleiter zu montieren, wobei der Lichtleitermontageteil (12) dafür konfiguriert ist, das Entweichen von Licht an einer Position, an der der Lichtleiter montiert ist, zu verhindern.

3. Leuchtstruktur (1) nach einem der Ansprüche 1-2, wobei der Lichtleitraum-definierende Abschnitt (10) und der Halteabschnitt (20) gemeinsam durch einen integralen Formungsprozess hergestellt werden.

4. Leuchtstruktur (1) nach einem der Ansprüche 1-3, wobei der Halteabschnitt (20) so konfiguriert ist, dass er Haltearme (21, 22) zum Halten des Schaltkreissubstrats (100) aufweist, und mindestens einer der Haltearme (21, 22) des Weiteren dafür konfiguriert ist, einen Positionierungsraum zu definieren, in den eine auf dem Schaltkreissubstrat (100) montierte Komponente eingepasst wird, um die Leuchtstruktur (1) in Bezug auf das Schaltkreissubstrat (100) zu positionieren.

5. Leuchtstruktur (1) nach Anspruch 4, wobei mindestens einer der Haltearme (21, 22) aus einem elastischen Material hergestellt ist, so dass, wenn die Haltearme (21, 22) beginnen, das Schaltkreissubstrat (100) zu halten, der mindestens eine der Haltearme (21, 22) gebogen wird, um eine Distanz zwischen jeweiligen sich erstreckenden Enden der Haltearme (21, 22) zu vergrößern, um es zu ermöglichen, einen Randteil des Schaltkreissubstrats (100) zwischen die Haltearme (21, 22) einzuführen, während die auf dem Schaltkreissubstrat (100) montierte Komponente in den Positionierungsraum eingepasst wird.

6. Leuchtstruktur nach einem der Ansprüche 1-5, wobei das weiche und elastische Material ein weicher Gummi oder ein thermoplastisches Elastomer ist.

7. Leuchtstruktur nach den Ansprüchen 5-6, wobei das weiche und elastische Material ein Silikonkautschuk ist.

8. Vorrichtung, die eine Leuchtstruktur (1) umfasst, welche umfasst:
einen Lichtleitraum-definierenden Abschnitt (10), der dafür konfiguriert ist, einen Lichtleitraum (11) zu definieren, der eine Lichtempfangsöffnung (11r) und eine Lichtabstrahlungsöffnung (11e) aufweist, wobei der Lichtleitraum (11) dafür konfiguriert ist, Licht, das durch eine auf einem Schaltkreissubstrat (100) angeordnete Lichtquelle ausgesendet wird, durch die Empfangsöffnung (11r) hindurch zu empfangen und das herangeführte Licht so zu reflektieren, dass es durch die Emissionsöffnung (11e) hindurch strahlt, wobei eine Innenwand des Lichtleitraums (11) eine spiegelartige Oberfläche aufweist; und
einen Halteabschnitt (20), der neben dem Lichtleitraum-definierenden Abschnitt entlang eines Randteils des Schaltkreissubstrats zum Halten des Randteils des Schaltkreissubstrats (100) angeordnet ist, wobei mindestens ein Teil des Lichtleitraum-definierenden Abschnitts (10), der an dem Randteil des Schaltkreissubstrats (100) anliegt, und ein Teil des Halteabschnitts (20), der an dem Schaltkreissubstrat (100) anliegt, aus einem weichen und elastischen Material hergestellt sind.

9. Vorrichtung nach Anspruch 8, wobei die Vorrichtung ein elektronisches Gerät ist.

10. Vorrichtung nach Anspruch 9, wobei das elektronische Gerät eine Set-Top-Box oder ein DVD-, BluRay- oder Festplattenrekorder ist.

11. Vorrichtung nach Anspruch 8, wobei der Lichtleitraum-definierende Abschnitt (10) einen Lichtleitermontageteil (12) aufweist, der so konfiguriert ist, dass er von einem die Lichtabstrahlungsöffnung umgebenden Teil, der die Lichtabstrahlungsöffnung (11e) umgibt, vorsteht, um daran einen Lichtleiter zu montieren, wobei der Lichtleitermontageteil (12) dafür konfiguriert ist, das Entweichen von Licht an einer Position, an der der Lichtleiter montiert ist, zu verhindern.

12. Vorrichtung nach Anspruch 8 oder 11, wobei der Lichtleitraum-definierende Abschnitt (10) und der Halteabschnitt (20) gemeinsam durch einen integralen Formungsprozess hergestellt werden.

13. Vorrichtung nach einem der Ansprüche 8, 11 und 12, wobei der Halteabschnitt (20) so konfiguriert ist, dass er Haltearme (21, 22) zum Halten des Schaltkreissubstrats (100) aufweist, und mindestens einer der Haltearme (21, 22) des Weiteren dafür konfiguriert ist, einen Positionierungsraum zu definieren, in den eine auf dem Schaltkreissubstrat (100) montierte Komponente eingepasst wird, um die Leuchtstruktur (1) in Bezug auf das Schaltkreissubstrat (100) zu positionieren.

14. Vorrichtung nach Anspruch 13, wobei mindestens einer der Haltearme (21, 22) aus einem elastischen Material hergestellt ist, so dass, wenn die Haltearme (21, 22) beginnen, das Schaltkreissubstrat (100) zu halten, der mindestens eine der Haltearme (21, 22) gebogen wird, um eine Distanz zwischen jeweiligen sich erstreckenden Enden der Haltearme (21, 22) zu vergrößern, um es zu ermöglichen, einen Randteil des Schaltkreissubstrats (100) zwischen die Haltearme (21, 22) einzuführen, während die auf dem Schaltkreissubstrat (100) montierte Komponente in den Positionierungsraum eingepasst wird.

15. Vorrichtung nach einem der Ansprüche 8 und 11 bis 14, wobei das weiche Material ein weicher Gummi oder ein thermoplastisches Elastomer ist.

## Revendications

1. Structure électroluminescente (1) comprenant :
une portion de définition d'espace de guidage lumineux (10) configurée pour définir un espace de guidage lumineux (11) ayant une ouverture de réception lumineuse (11r) et une ouverture d'émission lumineuse (11e), l'espace de guidage lumineux (11) étant configuré pour recevoir une lumière émise par une source lumineuse prévue sur un substrat de circuit (100) à travers l'ouverture de réception (11r) et réfléchir la lumière introduite pour qu'elle rayonne à travers l'ouverture d'émission (11e), dans laquelle une paroi intérieure de l'espace de guidage lumineux (11) a une surface de type miroir ; et
une portion de maintien (20) prévue adjacente à la portion de définition d'espace de guidage lumineux le long d'une partie de bord du substrat de circuit pour maintenir la partie de bord du substrat de circuit (100), dans laquelle au moins une partie de la portion de définition d'espace de guidage lumineux (10) venant en butée contre la partie de bord du substrat de circuit (100) et une partie de la portion de maintien (20) venant en butée contre le substrat de circuit (100) sont constituées d'un matériau souple et élastique.

2. Structure électroluminescente (1) selon la revendication 1, dans laquelle la portion de définition d'espace de guidage lumineux (10) a une partie de montage de guide lumineux (12) configurée pour faire saillie depuis une partie entourant l'ouverture d'émission lumineuse qui entoure l'ouverture d'émission lumineuse (11e) pour qu'un guide lumineux y soit monté, dans laquelle la partie de montage de guide lumineux (12) est configurée pour empêcher une fuite de lumière à une position à laquelle le guide lumineux est monté.

3. Structure électroluminescente (1) selon la revendication 1 ou 2, dans laquelle la portion de définition d'espace de guidage lumineux (10) et la portion de maintien (20) sont produites conjointement par un processus de moulage intégral.

4. Structure électroluminescente (1) selon l'une quelconque des revendications 1 à 3, dans laquelle la portion de maintien (20) est configurée pour avoir des bras de maintien (21, 22) pour maintenir le substrat de circuit (100), et au moins l'un des bras de maintien (21, 22) est en outre configuré pour définir un espace de positionnement pour qu'un composant monté sur le substrat de circuit (100) soit ajusté dans celui-ci de manière à positionner la structure électroluminescente (1) par rapport au substrat de circuit (100).

5. Structure électroluminescente (1) selon la revendication 4, dans laquelle au moins l'un des bras de maintien (21, 22) est constitué d'un matériau élastique de sorte que, lorsque les bras de maintien (21, 22) commencent à maintenir le substrat de circuit (100), l'au moins un des bras de maintien (21, 22) soit plié pour augmenter une distance entre des extrémités d'extension respectives des bras de maintien (21, 22) afin de permettre l'insertion d'une partie de bord du substrat de circuit (100) entre les bras de maintien (21, 22) pendant que le composant monté sur le substrat de circuit (100) est ajusté dans l'espace de positionnement.

6. Structure électroluminescente selon l'une des revendications 1 à 5, dans laquelle le matériau souple et élastique est un élastomère caoutchouc ou thermoplastique souple.

7. Structure électroluminescente selon la revendication 5 ou 6, dans laquelle le matériau souple et élastique est un caoutchouc de silicium.

8. Dispositif comprenant une structure électroluminescente (1) comprenant :
une portion de définition d'espace de guidage lumineux (10) configurée pour définir un espace de guidage lumineux (11) ayant une ouverture de réception lumineuse (11r) et une ouverture d'émission lumineuse (11e), l'espace de guidage lumineux (11) étant configuré pour recevoir une lumière émise par une source lumineuse prévue sur un substrat de circuit (100) à travers l'ouverture de réception (11r) et réfléchir la lumière introduite pour qu'elle rayonne à travers l'ouverture d'émission (11e), dans lequel une paroi intérieure de l'espace de guidage lumineux (11) a une surface de type miroir ; et
une portion de maintien (20) prévue adjacente à la portion de définition d'espace de guidage lumineux le long d'une partie de bord du substrat de circuit pour maintenir la partie de bord du substrat de circuit (100), dans lequel au moins une partie de la portion de définition d'espace de guidage lumineux (10) venant en butée contre la partie de bord du substrat de circuit (100) et une partie de la portion de maintien (20) venant en butée contre le substrat de circuit (100) sont constituées d'un matériau souple et élastique.

9. Dispositif selon la revendication 8, dans lequel le dispositif est un appareil électronique.

10. Dispositif selon la revendication 9, dans lequel l'appareil électronique est un décodeur ou un enregistreur de DVD, Blu-Ray ou disque dur.

11. Dispositif selon la revendication 8, dans lequel la portion de définition d'espace de guidage lumineux (10) a une partie de montage de guide lumineux (12) configurée pour faire saillie depuis une partie entourant l'ouverture d'émission lumineuse qui entoure l'ouverture d'émission lumineuse (11e) pour qu'un guide lumineux y soit monté, dans lequel la partie de montage de guide lumineux (12) est configurée pour empêcher une fuite de lumière à une position à laquelle le guide lumineux est monté.

12. Dispositif selon la revendication 8 ou 11, dans lequel la portion de définition d'espace de guidage lumineux (10) et la portion de maintien (20) sont produites conjointement par un processus de moulage intégral.

13. Dispositif selon l'une quelconque des revendications 8, 11 et 12, dans lequel la portion de maintien (20) est configurée pour avoir des bras de maintien (21, 22) pour maintenir le substrat de circuit (100), et au moins l'un des bras de maintien (21, 22) est en outre configuré pour définir un espace de positionnement pour qu'un composant monté sur le substrat de circuit (100) soit ajusté dans celui-ci de manière à positionner la structure électroluminescente (1) par rapport au substrat de circuit (100).

14. Dispositif selon la revendication 13, dans lequel au moins l'un des bras de maintien (21, 22) est constitué d'un matériau élastique de sorte que, lorsque les bras de maintien (21, 22) commencent à maintenir le substrat de circuit (100), l'au moins un des bras de maintien (21, 22) soit plié pour augmenter une distance entre des extrémités d'extension respectives des bras de maintien (21, 22) afin de permettre l'insertion d'une partie de bord du substrat de circuit (100) entre les bras de maintien (21, 22) pendant que le composant monté sur le substrat de circuit (100) est ajusté dans l'espace de positionnement.

15. Dispositif selon l'une quelconque des revendications 8 et 11 à 14, dans lequel le matériau souple est un élastomère caoutchouc ou thermoplastique souple.
